(19) **Europäisches Patentamt**
**European Patent Office**
**Office européen des brevets**

(11) **EP 3 764 548 B1**

(12) # EUROPEAN PATENT SPECIFICATION

(45) Date of publication and mention
of the grant of the patent:
**23.08.2023 Bulletin 2023/34**

(21) Application number: **19460036.7**

(22) Date of filing: **09.07.2019**

(51) International Patent Classification (IPC):
***H03M 7/30*** *(2006.01)*

(52) Cooperative Patent Classification (CPC):
**H03M 7/3064; H03M 7/3071; H03M 7/70**

(54) **METHOD, COMPUTER PROGRAM, AND COMPUTER SYSTEM FOR LOSSLESS COMPRESSION OF A MULTICHANNEL ELECTROCARDIOGRAM SIGNAL**

VERFAHREN, COMPUTERPROGRAMM UND COMPUTERSYSTEM ZUR VERLUSTLOSEN KOMPRIMIERUNG EINES MEHRKANALIGEN ELEKTROKARDIOGRAMMSIGNALS

PROCÉDÉ, PROGRAMME INFORMATIQUE ET SYSTÈME INFORMATIQUE POUR LA COMPRESSION SANS PERTE D'UN SIGNAL D'ÉLECTROCARDIOGRAMME MULTICANAUX

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**13.01.2021 Bulletin 2021/02**

(73) Proprietor: **Comarch Healthcare Spólka Akcyjna 31-864 Kraków (PL)**

(72) Inventor: **Rzepka, Dominik 31-444 Kraków (PL)**

(56) References cited:
**EP-A2- 1 995 685**

• **Ignacio Capurro et al: "Efficient sequential compression of multi-channel biomedical signals", internet article, 14 May 2016 (2016-05-14), XP002796888, Retrieved from the Internet: URL:https://arxiv.org/pdf/1605.04418.pdf [retrieved on 2020-01-13]**
• **Dong-Sun Kim, Jinsan Kwon: "A Lossless Multichannel Bio-Signal Compression Based on Low-Complexity Joint Coding Scheme for Portable Medical Devices", internet article, 2014, XP002796889, Retrieved from the Internet: URL:https://www.semanticscholar.org/paper/ A-Lossless-Multichannel-Bio-Signal-Compres sion-on-Kim-Kwon/3dce5058b24f9f61773e206f6 960595388a3efbd [retrieved on 2020-01-10]**

• **C. J. Deepu, Y. Lian: "A Joint QRS Detection and Data Compression Scheme for Wearable Sensors", IEEE TRANSACTIONS ON BIOMEDICAL ENGINEERING, vol. 62, no. 1 January 2015 (2015-01), XP002796890, Retrieved from the Internet: URL:https://ieeexplore.ieee.org/stamp/stam p.jsp?tp=&arnumber=6863633 [retrieved on 2020-01-10]**
• **Qiang Liu, Mingui Sun, Robert J. Sclabassi: "Decorrelation of Multichannel EEG Based on Hjorth Filter and Graph Theory", internet article, ICSP '02 Proceedings, 2002, XP002796891, Retrieved from the Internet: URL:https://ieeexplore.ieee.org/stamp/stam p.jsp?tp=&arnumber=1180083&tag=1 [retrieved on 2020-01-13]**
• **Dominik Rzepka: "Low-complexity lossless multichannel ECG compression based on selective linear prediction", Biomedical Signal Processing and Control, vol. 57 March 2020 (2020-03), XP002796892, Retrieved from the Internet: URL:https://www.sciencedirect.com/science/ article/pii/S1746809419302861 [retrieved on 2020-01-14]**

**Description**

FIELD OF THE INVENTION

The present invention relates to a method for lossless compression of a multichannel electrocardiogram signal, dedicated for portable systems of electrocardiogram (ECG) data acquisition. It also relates to a computer program and computer system to carry out the method according to the invention.

DESCRIPTION OF PRIOR ART

Remote monitoring of heart condition is becoming increasingly popular, since the heart diseases are presently one of the major causes of death. The main diagnostic signal used for the heart diagnosis is the electrocardiogram (ECG), collected using electrodes placed at the patient's body and device converting the analog signal into digital, discrete time sample. In some systems the automated diagnosis using ECG is performed directly in the portable device carried by a patient. For example, publication "Implementation of a portable device for real-time ECG signal analysis", Taegyun Jeon, Byoungho Kim, Moongu Jeon and Byung-Geun Lee, BioMedical Engineering OnLine 2014 describes a portable ECG device with compact and effective architecture for detecting atrial fibrillation (AFib) and myocardial ischemia. The device allows real-time electrocardiogram (ECG) signal acquisition and analysis for cardiac diseases. This device has been built and evaluated for high quality of signals, accurate detection as well as low computational complexity. Because of reduced computational complexity, the ARM processor was able to process up to a thousand samples per second, and this allowed real-time acquisition and diagnosis of heart disease.

Such an approach, however, limits the complexity of the signal processing methods, due to power consumption constraints of battery powered portable devices. On the other hand, there are strong arguments for increase of complexity. The main advantage of remote monitoring of heart condition is allowing patients to lead their normal life without need for keeping them in the hospital. As a consequence, the quality of the ECG signal collected from the patients during their daily routines is sometimes very bad, due to moves of the electrodes and electrical activity of muscles. Providing high reliability of the motoring system is therefore a strong motivation for processing multiple records of ECG simultaneously, to provide redundancy. In such case it may be more advantageous to send the ECG signal using wireless link to the central processing system and perform analysis there. Obviously this solution is effective only when the energy requirements of the data transmission is smaller than the that of the advanced processing in the portable. Effectiveness of the transmission can be increased if the volume of the data is decreased using energy-efficient compression method. In the paper entitled "A Joint QRS Detection and Data Compression Scheme for Wearable Sensors" C. J. Deepu and Y. Lian, IEEE Trans. Biomed. Engineering a novel electrocardiogram (ECG) processing technique for joint data compression and QRS detection in a wireless wearable sensor is presented. The proposed algorithm is aimed at lowering the average complexity per task by sharing the computational load among multiple essential signal-processing tasks needed for wearable devices. The compression algorithm, which is based on an adaptive linear data prediction scheme, achieves a lossless bit compression ratio of 2.286x. Lower overall complexity and good performance renders the proposed technique suitable for wearable/ambulatory ECG devices.

Lossy compression methods significantly outperform lossless ones in terms of the compression ratio, at the cost of introduced distortions. Unfortunately, lossy methods often cannot be used in the ECG processing, because of the compliance with the medical norms for the ECG acquisition devices, strictly constraining processing distortion.

The problem is therefore limited to finding the lossless compression method yielding the high compression rate given the limited computational resources. The latter requirement severely limits the applicability of advanced algorithms, based for example on the adaptive wavelet transform, neural networks, Burrows-Wheeler transformation or clustering. Low complexity compression methods are based on delta encoding, linear prediction coding (LPC) or adaptive linear prediction. In the paper titled "A lossless multichannel bio-signal compression based on low-complexity joint coding scheme for portable medical devices" D.-S. Kim and J.-S. Kwon, Sensors, Sep. 2014 is described a multichannel hardware encoder based on a low-complexity joint-coding technique and shared multiplier scheme for portable devices. A joint-coding decision method and a reference channel selection scheme are modified for a low-complexity joint coder. The proposed joint coding decision method determines the optimized joint-coding operation based on the relationship between the cross correlation of residual signals and the compression ratio. The reference channel selection is designed to select a channel for the entropy coding of the joint coding. The hardware encoder operates at a 40 MHz clock frequency and supports two-channel parallel encoding for the multichannel monitoring system. Experimental results show that the compression ratio increases by 0.06%, whereas the computational complexity decreases by 20.72% compared to the MPEG-4 ALS reference software encoder. In addition, the compression ratio increases by about 11.92%, compared to the single channel based bio-signal lossless data compressor. In the paper with title "Efficient sequential compression of multi-channel biomedical signals" by Ignacio Capurro et al., published on 14-05-2016, another method for losslessly compressing multichannel EGC signals is disclosed.

The patent US8917779 B2 discloses a system for electrocardiogram signal compression and de-compression. The invention uses the sign characteristics of the coefficients of the discrete cosine transform type IV and the characteristics of quantization of spectrum to perform the differential pulse code modulation of the spectrum for preserving the high frequency characteristics of the spectrum of the discrete Fourier transform. The invention also uses the Huffman coding to increase the compression ratio. Different from the conventional compression technology, the invention uses the fact that the quantization values of the spectrum in the high frequency are almost the same to increase the compression ratio and preserve the characteristics of high frequency components of the spectrum.

European patent EP1574067 B1 describes a method and apparatus for processing or compressing an n-dimensional digital signal by constructing a sparse representation which takes advantage of the signal geometrical regularity. The invention comprises a warped wavelet packet transform which performs a cascade of warped subband filtering along warping grids of sampling points adapted to the signal geometry. It also comprises a bandeletisation which decorrelates the warped wavelet packet coefficients to produce a sparse representation. An inverse warped wavelet packet transform and an inverse bandeletisation reconstruct a signal from its bandelet representation. The invention comprises a compression system which quantizes and codes the bandelet representation, a decompression system, a restoration system which enhances a signal by filtering its bandelet representation, and a feature vector extraction system for pattern recognition applications of a bandelet representation.

## SUMMARY OF THE INVENTION

Accordingly, the objective of the present invention is to provide lossless multichannel ECG signals compression keeping the low computational cost and implementation simplicity. The main objective of the lossless compression is to represent a data using small number of bits by avoiding a statistical redundancy, while keeping the ability to recover the input data exactly.

In order to achieve the objective mentioned above, the present invention provides a method for lossless compression of a multichannel electrocardiogram signal carried out by a computer system as defined by claim 1. Preferred embodiments of such method are defined by dependent claims 2-8.

The present invention provides also a computer program comprising instructions which, when the program is executed by a computing device, causing the computing device to carry out the method for lossless compression of a multichannel electrocardiogram signal according to the invention.

Further, the invention relates also to a computer system arranged to carry out the method according to the invention.

The benefit of the invention is that the resulting compression method maintains low computational complexity as well as high compression efficiency, and can be easily implemented in a low-power ECG acquisition portable device. Thanks to lossless compression it is compliant with strict requirements of ECG processing, which enables it to be used both for automatic and manual diagnosis of heart condition, and a low delay of processing allows for using it in the on-line remote monitoring systems.

## BRIEF DESCRIPTION OF DRAWING

The invention is presented in the embodiment on drawing in which:

Fig. 1 is a block diagram presenting a general scheme of encoding according to the invention;

Fig. 2 is a block diagram presenting a general scheme of predictors training according to the invention;

Fig. 3 is a block diagram presenting a general scheme of decoding according to the invention;

Fig. 4a is a block diagram of the linear predictive encoder;

Fig. 4b is a block diagram of the linear predictive decoder;

Fig. 5a is a block diagram of the detector of heartbeats and selective linear predictive encoder;

Fig. 5b is a block diagram of the detector of heartbeats and selective linear predictive decoder;

Fig. 6a is a block diagram of cross-channel predictive encoding;

Fig. 6b is a block diagram presenting cross-channel predictive decoding;

Fig. 7a is a block diagram of the cross-channel predictive encoder;

Fig. 7b is a block diagram of the cross-channel predictive decoder;

Fig. 8 is a block diagram of multiplexing during cross-channel predictive encoding and decoding;

Fig. 9a is a block diagram of connections between encoder and predictor training blocks;

Fig. 9b is a block diagram of connections between decoder and predictor training blocks;

Fig. 10 presents order of operations during predictor training;

Fig. 11 presents timing of the training and encoding stages.

## DETAILED DESCRIPTION OF THE INVENTION

The invention will now be described in more details in a preferred embodiment, with reference to the accompanying drawing figures.

The term decorrelation used in the patent specification should be understood as a process that is used to reduce correlation between samples of each signal and correlation between samples of signals in different channels.

The designation $x_m(k)$ stands for m-th channel of an input ECG signal recorded in one or more channels, comprising of numbers indexed by variable k.

The designation M stands for number of channels.

The designation $y_m^*(k)$ stands for signal $x_m(k)$ processed using delta encoding.

The designation $y_m(k)$ stands for signal $y_m^*(k)$ processed using overflow prevention.

The designation $z_m(k)$ stands for signal $y_m(k)$ processed using in-channel decorrelation during the encoding stage.

The designation $z_m^\dagger(k)$ stands for signal $y_m(k)$ processed using in-channel decorrelation in the predictors training phase.

The designation $v_m(k)$ stands for signal $z_m(k)$ processed using cross-channel decorrelation during the encoding stage.

The designation $v_m^\dagger(k)$ stands for signal $z_m(k)$ processed using cross-channel decorrelation in the predictors training phase.

The designation $c_{m,i}$ stands for number being result of entropy encoding of i-th block of signal $z_m(k)$.

The designation $a_{m,i}^{qrs}$ is a vector of in-channel heartbeat predictor coefficients for m-th channel and i-th block of signal.

The designation $A_i^{qrs}$ stands for matrix of in-channel heartbeat predictor coefficients for i-th block of signal, comprising of vectors $[a_{1,i}^{qrs}, \ldots, a_{M,i}^{qrs}]$

The designation $a_{m,i}^{bg}$ vector of in-channel background predictor coefficients for m-th channel and i-th block of signal.

The designation $A_i^{bg}$ stands for matrix of in-channel background predictor coefficients for i-th block of signal, comprising of vectors $[a_{1,i}^{bg}, \ldots, a_{M,i}^{bg}]$.

The designation $b_{m,j}$ stands for vector of cross-channel predictor coefficients for m-th channel and i-th block of signal.

The designation 8 stands for matrix of cross-channel background predictor coefficients for i-th block of signal

comprising of vectors $[\mathbf{b}_{1,i}, \ldots, \mathbf{b}_{M,i}]$ .

The designation $N_i(m)$ stands for function mapping m-th channel to its reference channel, which is used for cross-channel prediction in i-th block of signal.

The main objective of lossless compression is to represent the data (e.g. ECG data) using smaller number of bits by avoiding a statistical redundancy, while keeping the ability to recover the input data exactly. For a device in portable systems of electrocardiogram (ECG) data acquisition the low computational cost and implementation simplicity is more important than the optimality of the compression ratio. Furthermore, the data must be transmitted without excessive delay, since the device may be used for the online monitoring of a patient's condition.

The method and the computer program according to the invention is designated to be performed by and implemented in such portable ECG devices.

A typical removal of statistical redundancy of a signal can be divided into two main stages: a decorrelation and an entropy coding.

The decorrelation stands for processing the samples of the signal in order to reduce its entropy, which is possible if samples are statistically dependent. In such a case the value of a sample can be approximately predicted using the values of other samples, to the degree to which the samples are statistically dependent. The parameters of the predictor reflect samples' dependence and should be obtained from a statistical analysis of the input. The predicted signal is subtracted from the original signal and the residual error is expected to have lower entropy than the original one. The prediction can rely on the previous samples of the signal (in-channel decorrelation) or on the samples from the other signal (cross-channel decorrelation).

The entropy coding stands for expressing the samples of a signal using symbols with variable bit width, which is on average smaller than the bit width of the binary symbols encoding input signal. The optimal encoding requires the knowledge of the residual error distribution and the method of assigning symbols of bit width equal to the amount of information carried by each sample of the residual error.

The estimation of the samples' dependence and residual error distribution can be performed with the use of different models of prediction. The most common models are: the fixed prediction, the adaptive prediction, the training sequence prediction, and the block prediction.

In the first prediction model i.e. fixed prediction, the characteristics of the signal is assumed a priori, and is not evaluated during encoding, but rather hard-coded into the structure of the codec. Due to lack of flexibility, the performance with nonstationary signals is suboptimal. In the second model - adaptive prediction - the characteristics of the signal is estimated for every sample from the properties of the preceding samples. This approach suits particularly well to the nonstationary signals. Additional advantage is that the coefficients of the predictor do not have to be sent along the compressed samples, since they can be calculated from the recovered signal in the decoder. In the third prediction model - training sequence prediction - the signal is divided into blocks and the characteristics of the signal is analyzed using training sequence preceding every block. This method is applicable to the signals whose characteristics does not change substantially during the length of the block. The presence of the training sequence introduces a processing delay between encoding and decoding of the samples. The prediction coefficients must be added to the encoded signal only for the first block, since for the others it can be calculated in the decoder from the recovered signal of the former block. In the last prediction model - the block prediction - the signal is divided into blocks and the prediction is performed on each block using coefficients obtained from prior block-wise statistical analysis. As a result the prediction coefficients are optimal on average, but may be suboptimal locally. Coefficients must be sent along each block of the encoded data to allow decoding.

To determine most suitable prediction model, the ECG signal characteristics must be known. The ECG signal $x_m(k)$ can be modeled as a sum of four components: a baseline wander $x_m^{bw}(k)$, an heartbeat component $x_m^{qrs}(k)$, an electromyographic noise $x_m^{emg}(k)$, and a background signal $x_m^{bg}(k)$.

$$x_m(k) = x_m^{bw}(k) + x_m^{qrs}(k) + x_m^{emg}(k) + x_m^{bg}(k)$$

The baseline wander $x_m^{bw}(k)$ is a slowly varying component (usually below 0.5 Hz) corresponding to the respiration and electrode impedance changes due to perspiration. The heartbeat component $x_m^{qrs}(k)$ consists of the PQRST complexes. The beats have similar shape and appear in similar distances. However, despite the similarity of consecutive intervals, the signal can be considered only quasi-periodic, since the rhythm tends to exhibit systematic variations (accelerations and decelerations). The electromyographic noise $x_m^{emg}(k)$ comes from the muscle activity and usually appears in the form of bursts. Its spectrum depends on the electrode arrangement, but most of the power is concentrated in the range $0 \div 500$ Hz. The background signal $x_m^{bg}(k)$ is an electrical noise, and in some cases also special type of heart activity, such as F-wave in atrial flutter. The background signal $x_m^{bg}(k)$ is assumed to have much smaller amplitude than the heartbeat component $x_m^{qrs}(k)$.

The baseline wander $x_m^{bw}(k)$ and the background noise $x_m^{bg}(k)$ can be considered as weakly nonstationary, while the heartbeat component $x_m^{qrs}(k)$ is quasi-periodic and the electromyographic noise $x_m^{emg}(k)$ is strongly nonstationary, but appears sporadically. This makes ECG signals quite different from audio signals, which exhibit clearly nonstationary characteristics. Thus, the most appealing approaches are the training sequence prediction and the block prediction. The processing delay of the block prediction approach makes it less attractive in the remote health monitoring. Therefore, the training sequence prediction is the preferred method of prediction for the estimation of the samples' dependence and residual error distribution. The length of block is determined by parameter $K_{block}$ and samples $k \in [(i - 1) \cdot K_{block} + 1, i \cdot K_{block}]$ of signals $x_m(k)$ belong to the $i$-th block.

An ECG signal $x_m(k)$ is usually recorded in one or more parallel channels. The number of channels M is usually in the range M = 1 ÷ 12. The signal is represented using fixed point numbers with 8 ÷ 16 bits and the sampling rate in the range $f_s = 125 \div 1000$ S/s. Inspection of the popular ECG databases indicates that the most common setup is 12-bit resolution and sampling rate $f_s \approx 250$ S/s .

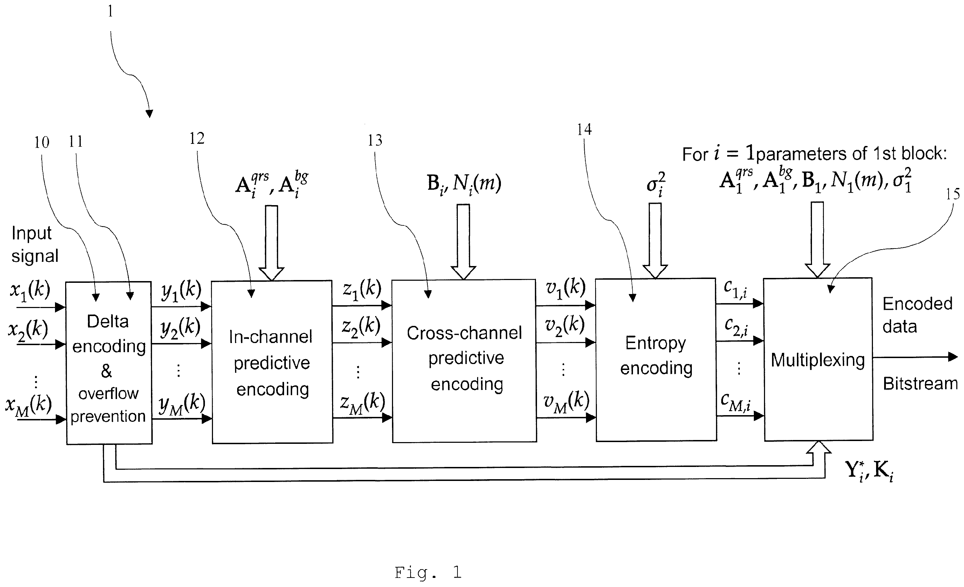

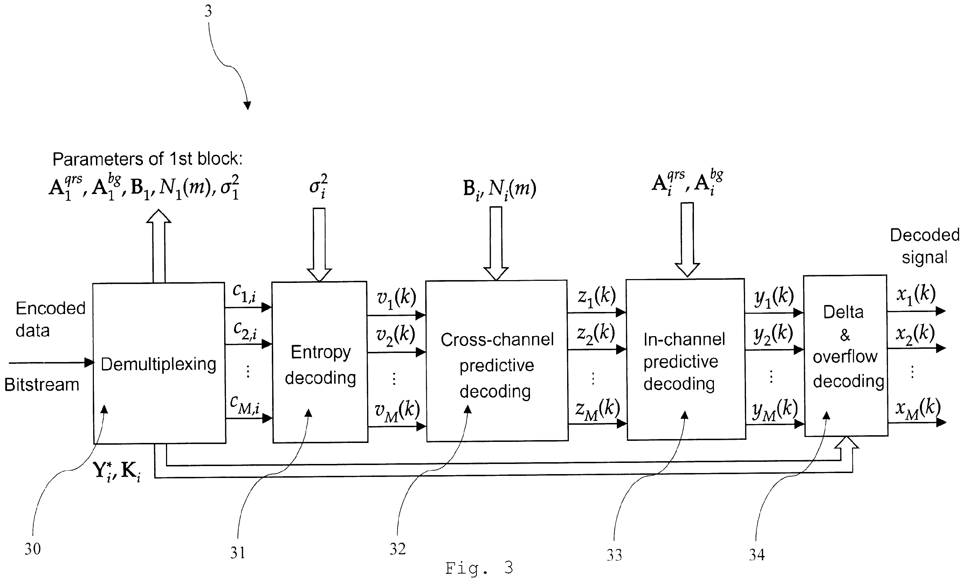

Referring to the drawing, Fig. 1 presents a general scheme of encoding 1 according to the invention. Encoding 1 is performed by the encoder. Analogously, Fig. 3 presents a general scheme of decoding 3 according to the invention, by reversing the operations performed during encoding 1. Decoding 3 is performed by the decoder. The encoder and decoder may be a software solutions or a hardware solutions e.g. the ASIC or FPGA circuits. The encoder can be implemented in a portable electrocardiogram (ECG) data acquisition device. The decoder can be implemented in a central processing system, where the data from the patients is received and analyzed. Such portable electrocardiogram (ECG) data acquisition device, central processing system, and means for data transmission (e.g. wireless network, Bluetooth Low Energy) between them form a computer system to carry out the method according to the invention. The computer program to perform the method is implemented in this computer system.

Encoding 1 starts with collecting input ECG signals $x_1(k), x_2(k), ..., x_M(k)$. The signals are collected from M parallel channels. The presence of the baseline wander $x_m^{bw}(k)$, which is independent on the other components of the ECG signal x(k) and has fixed low-pass characteristics allows to use the most straightforward predictor of the next sample: $\hat{x}_m(k) = x_m(k - 1)$. The prediction error in this case is obtained by differentiation: $y_m^*(k) = x_m(k) - \hat{x}_m(k)$. This prediction scheme is commonly known as a delta encoding 10. In result of delta encoding 10 the signal $y_m^*(k)$ is obtained. For most ECG signals $x_m(k)$, the output signal $y_m^*(k)$ of delta encoding 10 is on average smaller than its input - ECG signal $x_m(k)$, but in the event of abrupt change of baseline in the ECG, delta encoder produces a high-amplitude spike. Since signal is encoded using fixed-point representation, such amplitude increase must be handled to prevent 11 an overflow and data loss. Fortunately, these amplitude increases are rare, can be removed from the standard dataflow and treated as an additional delta encoding output. In order to perform overflow prevention 11 the high amplitude samples in $y_m(k)$ are detected and replaced by zeroes:

$$y_m(k) = \begin{cases} y_m^*(k) & |y_m^*(k)| < Y_{max}, \\ 0 & |y_m^*(k)| \geq Y_{max}. \end{cases}$$

The values $y_m^*(k)$ exceeding threshold $Y_{max}$ and the instants k for which this threshold was exceeded are gathered in the sets $y_{m,i}^*$ and $k_{m,i}$, where $i$ is an index of the processed block.

The sets $\mathbf{y}_{m,i}^*$ and $k_{m,i}$ for all channels $m \in 1, \ldots, M$ are aggregated into sets $[\mathbf{Y}^*, \mathbf{K}] = [\mathbf{y}_1^*, \mathbf{k}_1, \ldots, \mathbf{y}_M^*, \mathbf{k}_M]$.

The characteristics of other components of the ECG signal $x_m(k)$ i.e.: $x_m^{qrs}(k)$, $x_m^{emg}(k)$, $x_m^{bg}(k)$ cannot be accurately predicted a priori and the statistical analysis must be performed on the given signal. After decorrelation of the baseline wander $x_m^{bw}(k)$ into white noise by a delta encoder, the remaining components of the ECG signal $x_m(k)$ from each channel have to be decorrelated. According to the invention the decorrelation of the ECG signal is divided into the in-channel predictive encoding 12 and the cross-channel predictive encoding 13. In the in-channel predictive encoding 12 the prediction relies on the previous samples of the same signal. In the cross-channel predictive encoding 13 the prediction relies on the on the samples from the other signal.

The output signal $y_m(k)$ of the delta encoding 10 is firstly subjected to the in-channel predictive encoding 12. The predictive encoding is performed with the use of linear predictors.

The in-channel predictive encoding 12 can be obtained by subtraction of the linear prediction from the signal: $z_m(k) = y_m(k) - \hat{y}_m(k)$, where prediction is obtained using FIR filter

$$\hat{y}_m(k) = \sum_{\ell=0}^{L_{lp}-1} a_{m,i}(\ell) y_m(k - \ell).$$

$L_{lp}$ is the length of the filter.

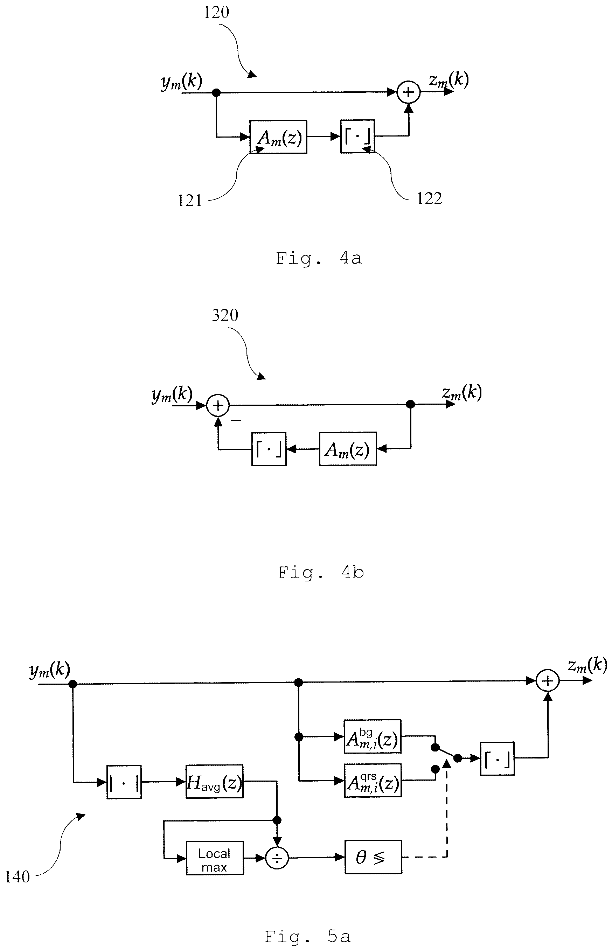

Since the coefficients $\mathbf{a}_{m,i} = [a_{m,i}(0), a_{m,i}(1), \ldots, a_{m,i}(L_{lp} - 1)]$ are usually not integers then to maintain an integer result of decorrelation required for the digital representation, the real-valued output of the filter must be transformed to integers (the notation $\lceil \cdot \rfloor$ stands for rounding to the nearest integer). The general scheme of a linear predictive encoder 120 used for the in-channel predictive encoding 12 is presented in Fig. 4a. The signal $y_m(k)$ is filtered 121 with the use of filter $A_{m,i}(z) = a_{m,i}(0) + a_{m,i}(1)z^{-1} + \ldots + a_{m,i}(L_{lp} - 1)z^{-L_{lp}}$ and the output of the filter is transformed 122 to integers. Next, the result is added to unfiltered signal $y_m(k)$. As a result of this linear prediction the output signal $z_m(k)$ is obtained.

The characteristics of the heartbeat $x_m^{qrs}(k)$ of the ECG signal $x_m(k)$ differs from the characteristics of the other components (electromyographic noise $x_m^{emg}(k)$ and background noise $x_m^{bg}(k)$). It is profitable to extract the heartbeat $x_m^{qrs}(k)$ to perform its prediction separately. The present invention takes advantage of this and uses separate linear predictors for decorrelating heartbeats and background components of the signal $y(k)$ during the in-channel predictive encoding 12.

Detection of heartbeats is performed with the use of detector of heartbeats and selective linear predictive encoder 140 which is presented in Fig. 5a. Notion "selective" indicates on switching between specialized predictors, for heartbeats and for background component of ECG signal.

According to the invention the heartbeats are detected with the use of a causal method which is based on the processing of a previous samples to decide whether currently processed samples contain an heartbeat. As a result it is not necessary to add the location of the beat to the output of the encoder, since it can be calculated from the already recovered samples in the decoder.

The criterion of distinguishing the heartbeat from the background relies on the comparison of the local signal's magnitude to the magnitude of the most recent extremum in last $K_{norm}$ samples, preceding the currently processed signal sample. In the absence of strong distortions and noise such an extremum usually corresponds to R-peak of heartbeat. The samples for which the ratio of the magnitudes exceeds the predefined threshold, are assumed to be the part containing the heartbeat. The magnitude of the recent R-peak is approximated by averaging the rectified input signal,

$$y_m^{avg}(k) = \sum_{\ell=1}^{L_{avg}} h_{avg}(\ell) |y_m(k - \ell)|$$

where coefficients of averaging filter $H_{avg}(z)$ are given by $h_{avg}(\ell) = \frac{1}{L_{avg}}$ for $\ell \in 1, ..., L_{avg}$. The indication of the beat presence is calculated by comparing the threshold $\theta$ to the normalized signal

$$\bar{y}_m^{avg}(k) = \frac{y_m^{avg}(k)}{\max_{k \in (k-K_{norm},k)} y_m^{avg}(k)}.$$

Depending on the result of the comparison the decorrelation is performed using one of the predictors: $A_{m,i}^{bg}(z)$ for the background component or $A_{m,i}^{qrs}(z)$ or for the heartbeats.

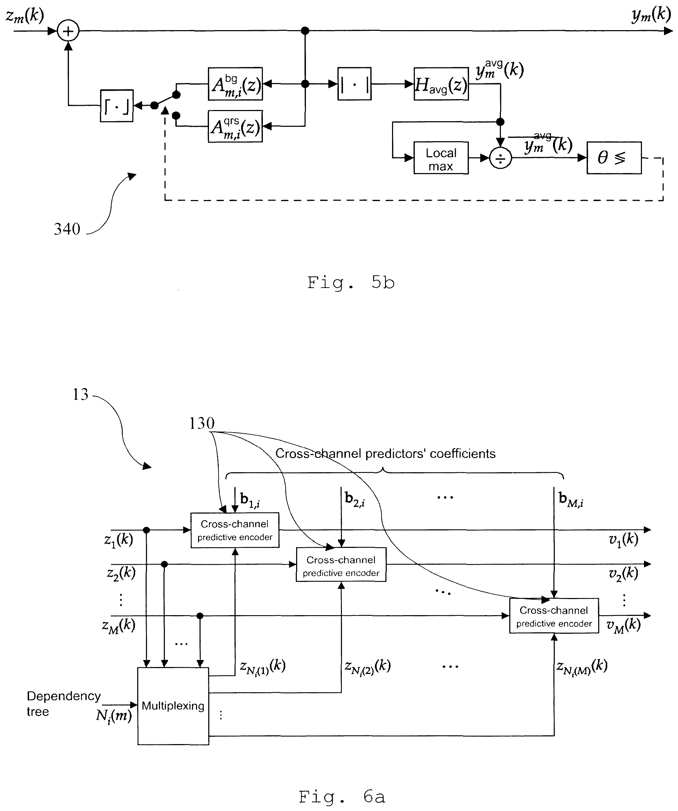

The detector of heartbeats and selective linear predictive decoder 340 which is used during decoding 3 is presented in Fig. 5b.

Referring back to Fig. 1 the next step of the method according to the invention, after the in-channel predictive encoding 12 is the cross-channel predictive encoding 13. Since the useful signal usually dominates over the background noise, then a substantial correlation between channels can be expected. The method according to the invention uses one channel to predict the values of the other one, so to optimize the choice of channel pairs and to maximize the number of channels benefiting from the prediction, the method arranges these pairs of channels into a tree of dependencies, such that one channel is used for prediction of the other channels, and the predicted channels are used for prediction of further channels.

This attribute of the ECG signal allows for an approximate linear prediction of the signal $z_m(k)$, using the the signal $z_n(k)$ from the other channel and the prediction coefficients $b_{m,i} = [b_{m,i}(0), b_{m,i}(2), ..., b_{m,i}(L_{ch} - 1)]$,

$$\hat{z}_m(k) = \sum_{\ell=0}^{L_{ch}-1} b_{m,i}(\ell) z_n(k - \ell).$$

The prediction error is given by

$$v_m(k) = \lceil z_m(k) - \hat{z}_m(k) \rfloor$$

The scheme of the cross-channel predictive encoding 13 block is presented in Fig 6a. Signals from each channel are fed into cross-channel predictive encoders 130 and also into set of multiplexers for multiplexing.

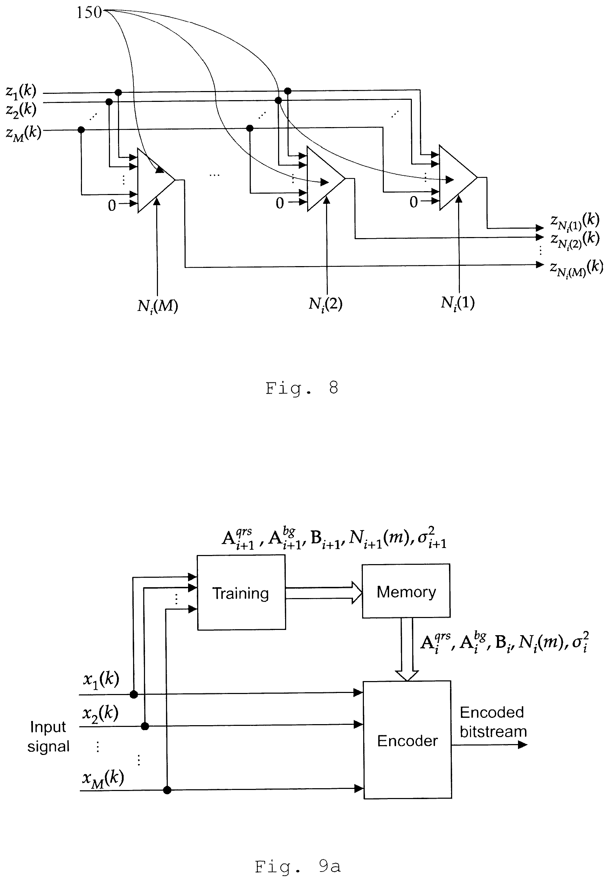

Multiplexing is shown in Fig. 8. Set of multiplexers 150 is driven by the assignment function $N_i(m)$, and allows for connecting m-th output with $N_i(m)$-th input, or with zero signal (in case where for given m we have $N_i(m) = \emptyset$).

Referring back to fig. 6a signals from the output of the multiplexing are fed into cross-channel predictive encoders 130 as a reference signals. In result of cross-channel prediction encoding 13 signal $v_m(k)$ is obtained. The cross-channel prediction encoding 22 is linear.

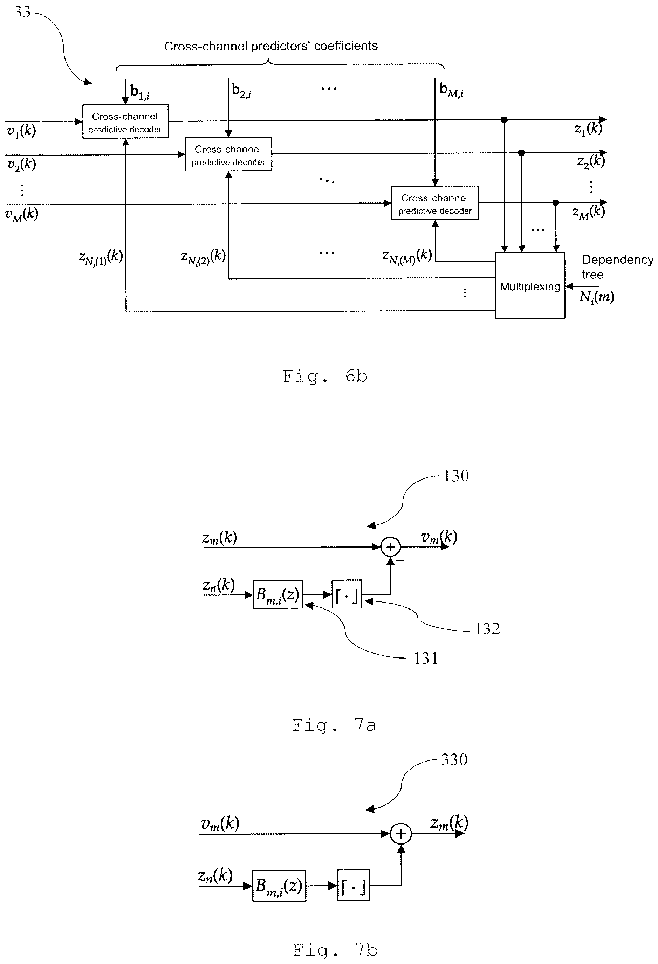

The cross-channel predictive encoder 130 is presented in fig. 7a. The input signal $z_m(k)$ is decorrelated with the use of a decorrelating signal $z_n(k)$. The decorrelating signal $z_n(k)$ is filtered 131 with the use of filter $B_{m,i}(z)$ and transformed 132 to integers. The choice of decorrelating signal $z_n(k)$ is determined during multiplexing. Next, the result is added to signal $z_m(k)$. As a result of this linear prediction the output signal $v_m(k)$ is obtained.

The next step of the method according to the invention is the entropy coding 14 with the use of variance of a prediction error. The entropy coding 14 is based on the principle of assigning the short codes to the more probable symbols and the longer codes to the less probable ones. The entropy coding 14 of a prediction error is performed with the use of any state-of-art method, which allows the arbitrary choice of a probability distribution of symbol occurrence, for example Asymmetric Numeral Systems method (ANS). The best performance was achieved by discretizing the t-Student distribution with the $\alpha=3$ degrees of freedom, with the probability distribution function (PDF) given by

$$pdf_V(v) = \frac{2}{\pi\sigma\left(1 + \frac{v^2}{\sigma^2}\right)},$$

and the cumulative density function

$$\mathrm{cdf}_V(v) = \frac{1}{2\pi}\left(\pi + \frac{2v}{v^2 + \sigma^2} + 2\arctan\left(\frac{v}{\sigma}\right)\right).$$

The result of encoding signal $v_m(k)$ in the i-th block is a number $C_{m,i}$.

The final step of encoding according to the invention is multiplexing $\underline{15}$. During this step multiplexer combines together multiple entropy encoded signals $c_{1,i}, c_{2,i}, ..., c_{M,i}$ from M channels, and outliers $\mathbf{Y}_i^*$, $\mathbf{K}_i$, into one encoded datastream. In the first block also estimated parameters $\mathbf{A}_1^{qrs}, \mathbf{A}_1^{bg}$, $\mathbf{B}_1$, $N_1(m)$, $\sigma_1^2$ are included. This encoded data is sent as a bitstream further to a decoder.

Fig. 3 presents a general scheme of decoding $\underline{3}$ according to the invention. Decoding $\underline{3}$ starts with collecting bitstream and demultiplexing $\underline{30}$ it into entropy encoded signals $c_{1,i}$, $c_{2,i}$, ..., $c_{M,i}$, outliers $\mathbf{Y}_i^*$, $K_i$, and for the first frame also parameters $\mathbf{A}_1^{qrs}, \mathbf{A}_1^{bg}$, $\mathbf{B}_1$, $N_1(m)$, $\sigma_1^2$. Next step of the method is entropy decoding $\underline{31}$ with the use of variance of a prediction error. The entropy decoding is performed by the decoder complementary with entropy encoder $\underline{14}$, and the result of decoding of the signal $c_{m,i}$ is signal $v_m(k)$ for i-th block.

The cross-channel linear predictive decoding $\underline{32}$ of signal $v_m(k)$ back into signal $z_m(k)$, is presented in Fig. 6b. It consists in reversing the operation performed by cross-channel linear predictive encoding $\underline{13}$, presented in Fig. 6a.

The cross-channel predictive decoding $\underline{33}$ uses the cross-channel predictive decoders $\underline{330}$. The cross-channel predictive decoders $\underline{330}$ are shown in Fig. 7b.

The in-channel linear predictive decoding $\underline{33}$ of signal $z_m(k)$ back into signal $y_m(k)$ consists in reversing the operation performed by in-channel linear predictive encoding $\underline{12}$. The in-channel predictive decoding $\underline{33}$ uses the in-channel predictive decoders $\underline{320}$, presented in Fig. 4b.

The delta decoding $\underline{34}$ of signal $y_m(k)$ into signal $x_m(k)$ consists in reversing the operations of delta coder. First, the high amplitude samples are restored from sets [Y*,K] to from $y_m^*(k)$ Then the signal x(k) is obtained using addition

$$x_m(k) = y_m^*(k) + x_m(k-1).$$

According to the invention the process of the compression and decompression of the electrocardiogram signal $x_m(k)$, described in details above, has to be preceded by a predictors training $\underline{2}$. Predictors training $\underline{2}$ is performed by the encoder and decoder. The encoder and decoder may be a software solutions or a hardware solutions e.g. the ASIC or FPGA circuits. The encoder can be implemented in a portable electrocardiogram (ECG) data acquisition device. The decoder can be implemented in a central processing system, where the data from the patients is received and analyzed.

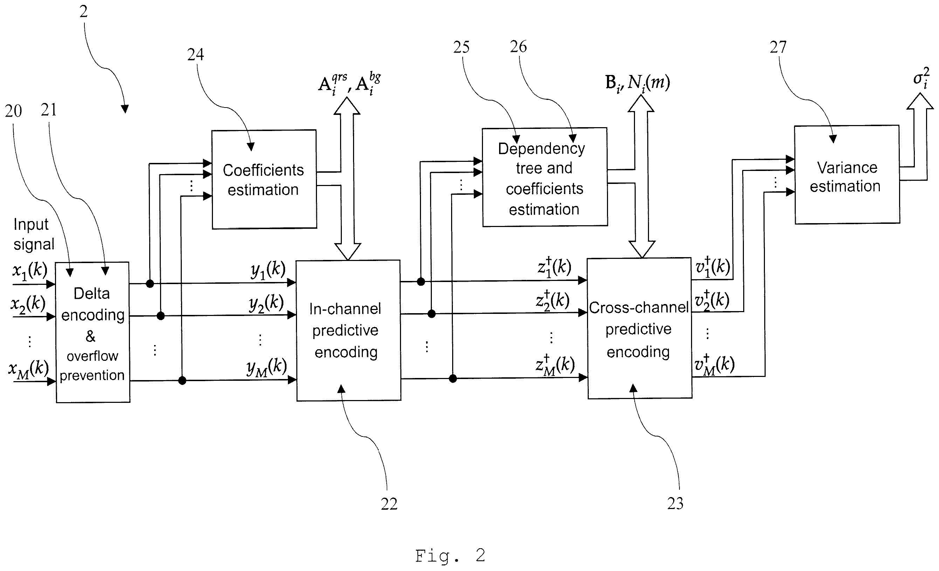

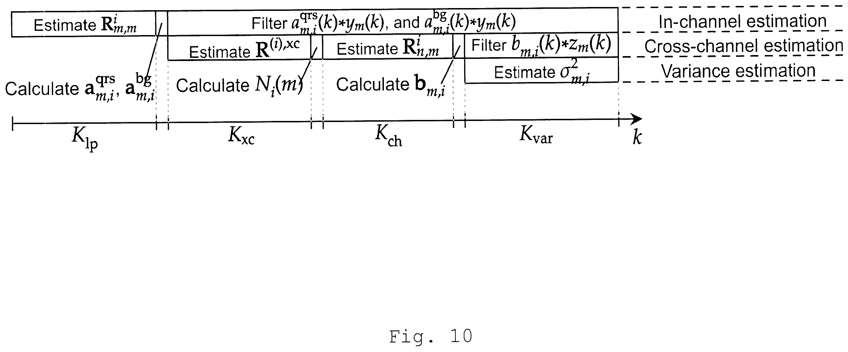

Block diagram of the predictors training $\underline{2}$ is presented in Fig. 2 and the steps of the prediction training $\underline{2}$ are presented chronologically in fig. 10. The signal $y_m(k)$ from each channel, after delta encoding $\underline{20}$ and overflow prevention $\underline{21}$, is decorrelated. The decorrelation is divided into in-channel predictive encoding $\underline{22}$ and cross-channel predictive encoding $\underline{23}$. The signal $y_m(k)$ from each channel, after delta encoding $\underline{20}$ and overflow prevention $\underline{21}$ is divided into heartbeats and background in the block in-channel predictive encoding block. During the in-channel predictive encoding $\underline{22}$ the estimation of $\mathbf{R}_{m,m}^{(i)}$ $(m \in M)$ and calculation of predictors coefficients $A_i^{qrs} = [\mathbf{a}_{1,i}^{qrs}, ..., \mathbf{a}_{M,i}^{qrs}]$ and $A_i^{bg} = [\mathbf{a}_{1,i}^{bg}, ..., \mathbf{a}_{M,i}^{bg}]$ is performed $\underline{24}$.

The calculation of coefficients of the filter $A_{m,i}(z)$ based on the spectrum of the signal $y_m(k)$ can be accomplished efficiently by solving the filtering equation

$$\mathbf{Y}_{m,i}\mathbf{a}_{m,i} = -\mathbf{y}_{m,i},$$

where

$$\mathbf{Y}_m = \begin{bmatrix} y_{m,i}(1) & 0 & \cdots & 0 \\ y_{m,i}(2) & y_{m,i}(1) & \ddots & 0 \\ \vdots & y_{m,i}(2) & \ddots & \vdots \\ y_{m,i}(K_{lp}) & \vdots & \ddots & y_{m,i}(1) \\ 0 & y_{m,i}(K_{lp}) & \ddots & y_{m,i}(2) \\ 0 & 0 & \ddots & \vdots \\ 0 & 0 & \cdots & y_{m,i}(K_{lp}) \end{bmatrix}$$

is a $(K_{lp} + L_{lp}) \times L_{lp}$ dimensional convolution matrix and the right-hand side $(K_{lp} + L_{lp}) \times 1$ dimensional vector is given by

$$y_{m,i} = \left[ y_{m,i}(2), y_{m,i}(3), \dots, y_{m,i}(K_{lp}), 0, \dots, 0 \right]^T.$$

The signal $y_{m,i}(k)$ is the part of the signal $y_m(k)$ used for the training of the predictor $A_{m,i}(z)$, which is further applied for decorrelation of signal during *i*-th block of signal.

The constants $K_{lp}$ and $L_{lp}$ are respectively the length of linear predictor training sequence and the length of the predictor $a_{m,i}$.

Solving the filtering equation $\mathbf{Y}_{m,i}\mathbf{a}_{m,i} = -y_{m,i}$, using a least squares method leads to the Yule-Walker equations

$$\mathbf{R}_{m,m}^{(i)}\mathbf{a}_{m,i} = -\mathbf{r}_{m,m}^{(i)},$$

with the autocorrelation matrix

$$\mathbf{R}_{m,m}^{(i)} = \begin{bmatrix} r_{m,m}^{(i)}(0) & r_{m,m}^{(i)}(1) & \cdots & r_{m,m}^{(i)}(L_{lp}-1) \\ r_{m,m}^{(i)}(1) & r_{m,m}^{(i)}(0) & \ddots & \vdots \\ \vdots & \ddots & \ddots & r_{m,m}^{(i)}(1) \\ r_{m,m}^{(i)}(L_{lp}-1) & \cdots & r_{m,m}^{(i)}(1) & r_{m,m}^{(i)}(0) \end{bmatrix}$$

and the autocorrelation vector

$$\mathbf{r}_{m,m}^{(i)} = \left[ r_{m,m}^{(i)}(1), r_{m,m}^{(i)}(2), \dots, r_{m,m}^{(i)}(L_{lp}) \right]^T.$$

The autocorrelation function of a signal $y_{m,i}(k)$ is given by

$$r_{m,n}^{(i)}(\ell) = \sum_{k=0}^{K-\ell-1} y_{m,i}(k)y_{n,i}(k+\ell)$$

with $n = m$ and it is calculated on the signal chunk of length $K = K_{lp}$.

The Yule-Walker equations can be solved efficiently with complexity $\mathcal{O}(L_{lp}^2)$ using the Levinson-Durbin method.

Then the in-channel predictive encoding 22 is performed and resulting signals $[z_1^\dagger(k), \dots, z_M^\dagger(k)]$ are fed to the cross-channel predictive encoding block. Next, during the cross-channel predictive encoding 23 the cross-channel correlation $R^{(i),xc}$ is estimated and tree of dependency $N_i(m)$ is determined 25. Moreover, the estimation of $\mathbf{R}_{n,n}^{(i)}$ and

$\mathbf{r}_{n,m}^{(i)}$ (where m E M and n = $N_i$(m)) and calculation of predictors coefficients $B_i = [b_{1,i}, ..., b_{M,i}]$ is performed 26.

Similarly as in the case of linear prediction filters, the coefficients $B_{m,i}(z) = b_{m,i}(0) + b_{m,i}(1)z^{-1}+...+b_{m,i}(L_{ch} - 1)z^{-L_{ch}+1}$ can be designed using filtering equation

$$\mathbf{Z}_{n,i}\mathbf{b}_{m,i} = \mathbf{z}_{m,i},$$

where $Z_{n,i}$ is $(K_{ch} + L_{ch}) \times L_{ch}$ dimensional convolution matrix for the signal $z_n(k)$, analogous to, and the right-hand side $(K_{ch} + L_{ch}) \times 1$ dimensional vector is given by

$$\mathbf{z}_{m,i} = \left[z_{m,i}(1), z_{m,i}(2), ..., z_{m,i}(K_{ch}), 0, ..., 0\right]^T.$$

The least-squares method gives

$$\mathbf{R}_{n,n}^{(i)}\mathbf{b}_{m,i} = \mathbf{r}_{n,m}^{(i)}$$

with $z_n(k)$ autocorrelation matrix $\mathbf{R}_{n,n}^{(i)}$. In contrast to Yule-Walker equations $\mathbf{R}_{m,m}^{(i)}\mathbf{a}_{m,i} = -\mathbf{r}_{m,m}^{(i)}$, the vector on the right-hand side of $\mathbf{R}_{n,n}^{(i)}\mathbf{b}_{m,i} = \mathbf{r}_{n,m}^{(i)}$ equations is the cross-correlation $r_{m,n}^{(i)}(\ell) = \sum_{k=0}^{K-\ell-1} z_{m,i}(k)z_{n,i}(k+\ell)$ between channels $z_m(k)$ and $z_n(k)$.

$$\mathbf{r}_{n,m}^{(i)} = \left[r_{n,m}^{(i)}(0), r_{n,m}^{(i)}(1), ..., r_{n,m}^{(i)}(L_{ch} - 1)\right]^T,$$

calculated on the signal chunk of length $K = K_{ch}$. The signals $z_{m,i}(k)$ and $z_{n,i}(k)$ are respectively parts of the signals $z_m(k)$ and $z_n(k)$ used for the training of the predictor $B_{m,i}(z)$, which is further applied for decorrelation of signal during $i$-th block.

Decoding signal $z_m(k)$ from $v_m(k)$ requires the knowledge of signal $z_n(k)$, coefficients $b_{m,i}$ and the assignment of the source channel for the prediction, denoted as n = $N_i$(m). The assignment function can be therefore defined as $N_i$(m): M → {M, Ø} where M = (1, ... , M) is a set of channel indices. In such case at least one channel (indexed with $n_0$) must be sent without such cross-channel decorrelation, to make possible decoding of the other channels. For this channel there is $N_i(n_0)$ = Ø and $b_{N_0,i}$ = 0. Next constraint is the absence of the reference loops - if the channel $n_1$ is used for prediction of the channel $n_2$ ($N_i(n_1)$ = $n_2$), then $n_2$ cannot be used for prediction of $n_1$ ($N_i(n_2) \neq n_1$). In general assignment function $N_i$(m) must follow,

$$N_i \circ N_i \circ \cdots \circ N_i(m) \neq m.$$

The cross-channel prediction starts from the channels m : $N_i$(m) = $n_0$, then continues to the channels m : $N_i(N_i(m))$ = $n_0$ and so on.

The method according to the invention proposes determining suboptimal assignment $N_i$(m) based on verifying the dependence between channels using the cross-channel correlation and determining the base channel $n_0$. The channel correlation matrix $R^{(i),xc}$ with elements

$$R_{n,m}^{(i),xc} = \frac{r_{n,m}^{(i)}(0)}{\sqrt{r_{n,n}^{(i)}(0)}\sqrt{r_{m,m}^{(i)}(0)}},$$

is calculated using $r^{(i)}_{m,n}(\ell) = \sum_{k=0}^{K-\ell-1} z_{m,i}(k) z_{n,i}(k+\ell)$ on the chunk of signals $z_{1,i}(k),...,z_{m,i}(k)$ of length $K = K_{xc}$. Then for each channel m the channel $N^{max}_i(m) \neq m$ with the highest correlation is found

$$N^{max}_i(m) := \underset{\hat{n} \in (1,...,M) \setminus \{m\}}{argmax} R^{(i),xc}_{\hat{n},m}$$

The channel with the highest correlation is chosen for a base reference

$$n_0 := \underset{\hat{n} \in (1,...,M)}{argmax} \sum_{m=1}^{M} [\,\hat{n} = N^{max}_i(m)\,].$$

Next, the assignment function $N_i(m)$ is found using the following procedure:

1. two set of channels are defined: connected

$$\mathcal{C} := \{n_0\}$$

and unconnected $\mathcal{U} := (1,...,M) \setminus n_0$ ;

2. all elements $m \in \mathcal{U}$ for which

$$N^{max}_i(m) \in \mathcal{C}$$

are moved from $\mathcal{U}$ to $\mathcal{C}$. For such elements $N_i(m) := N^{max}_i(m)$. If $\mathcal{U} = \emptyset$, the procedure is finished (all elements are connected). If $\mathcal{U} \neq \emptyset$ and no elements were transferred from $\mathcal{U}$ to $\mathcal{C}$, then step 3) is performed, otherwise step 2) is repeated;

3. the remaining elements $m \in \mathcal{U}$ for which

$$N^{max}_i(m) \notin \mathcal{C}$$

refer to each other, that is their most correlated channels do not belong to $\mathcal{C}$. Among such channels, the one with the highest correlation to a channel from $\mathcal{U}$ is found

$$(N^{conn}, m^{conn}) := \underset{\hat{n} \in \mathcal{C},\ \hat{m} \in \mathcal{U}}{argmax} R^{(i),xc}_{\hat{n},\hat{m}}$$

4. the channel $m^{conn}$ is moved from $\mathcal{U}$ to $\mathcal{C}$, and $N_i(m^{conn}) := N^{conn}$.

Then the step 2) is performed.

Then the cross-channel predictive encoding $\underline{23}$ is performed. The last step of the predictors training $\underline{2}$ is the estimation of prediction error variance $\underline{27}$ $\sigma^2_i = [\sigma^2_{1,i}, ..., \sigma^2_{M,i}]$ from the signals $[v^\dagger_1(k), ..., v^\dagger_M(k)]$. The variance estimation 27 is performed in parallel to the encoding during the final part of each block of length $K_{train} = K_{lp} + K_{xc} + K_{ch}$

+ $K_{var}$, to prepare the coefficients for the next block.

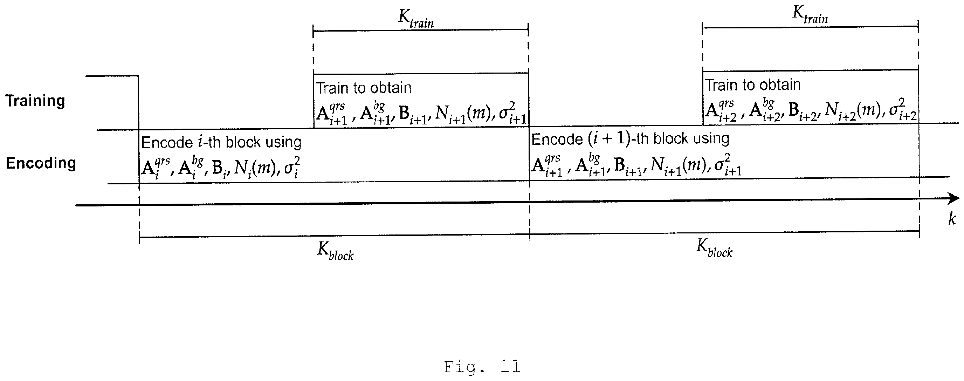

As seen in Fig. 11 predictors training 2 is performed periodically to avoid mismatch between the characteristics of the signal. Predictors training 2 in the encoder takes place in parallel with encoding 1, during the final part of each signal block. Predictors training 2 is finalized at the end of block, the compression parameters $\mathbf{A}_i^{qrs}, \mathbf{A}_i^{bg}$, $B_i$, $N_i(m)$ and $\sigma_i^2$ are latched in the memory, as shown in Fig. 9a, and used for encoding 1 of the next signal block.

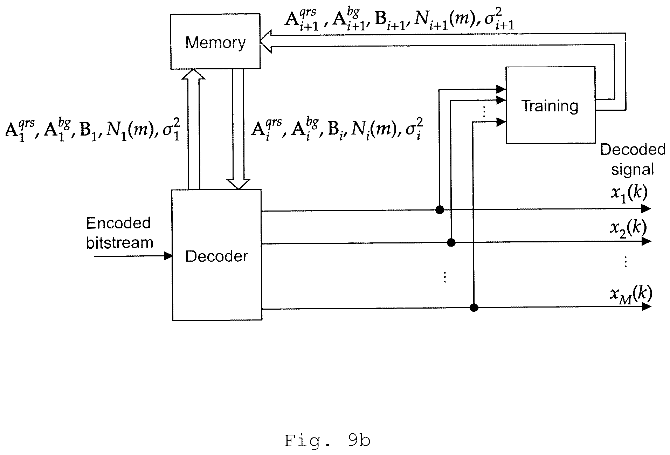

Predictors training 2 in the decoder 3 takes place after the signal from the previous block is decoded. The prediction parameters $\mathbf{A}_i^{qrs}, \mathbf{A}_i^{bg}$, $B_i$, $N_i(m)$, $\sigma_i^2$ has to be sent to decoder only along with the first block, since the parameters of the latter blocks can be estimated on the decoder's side using already decoded signal, as shown in Fig. 9b.

The result of a block encoding is a data stream $\mathbf{c_i} = [c_{1,i}, ..., c_{M,i}]$ and the set of outliers $\mathbf{Y}_i^*$, $\mathbf{K_i}$.

To investigate the impact of each individual technique included in the described algorithm on the final result, the tests of compression were performed with linear prediction (LP) or selective linear prediction (SLP), as well as with/without cross-channel linear prediction (XC-LP). The results strongly depend on the characteristics of the signals in database. The higher CR in INCARTDB database for pure in-channel prediction LP/SLP without XC-LP stems from the higher (and apparently excessive) number of bits than in MIT-BIH ADB arrhythmia database (16 bits compared to 11 bits). The positive impact of cross-channel prediction is evident in INCARTDB database because of the high number of channels (12 compared to 2), which facilitates finding highly similar channels. In the case of MIT-BIH ADB arrhythmia database there are only two channels available and (what is worse from the perspective of signal compression) the position of the electrodes are usually chosen in such a way that allows to see in one channel the beats which are poorly visible in the other. Such arrangement makes the shape of beats in channels radically different, which substantially reduces the effectiveness of linear cross-channel prediction.

Finally, average compression ratios of 2.92 and 3.4 for MIT-BIH ADB and INCARTDB respectively were achieved with the parameters listed in the table below.

| | Parameters |
|---|---|
| In-channel predictive encoding | $L_{qrs} = 4$, $L_{bg} = 4$, $L_{avg} = 3$, $\theta = 0.1$, $K_{norm} = 2s$, $K_{lp} = 4s$ |
| Cross-channel predictive encoding | $L_{ch} = 6$, $K_{xc} = 1s$, $K_{ch} = 4s$ |
| Entropy coding | $K_{var} = 2s$, PDF: t - Student $\alpha = 3$ (10) |
| Packetization | $K_{packet} = 120s$ |

The invention relates also to a computer program to carry out the method. The computer program is dedicated to be implemented in a low-power ECG portable device designed for acquisition of an ECG signal and sending it further to a decoder.

## Claims

1. A method for lossless compression of a multichannel electrocardiogram signal carried out by a computer system comprising:

   encoding (1),
   predictors training (2),
   decoding (3)
   wherein encoding (1) comprises following steps:

      delta encoding (10) performed on input ECG signals collected from M parallel channels,
      overflow prevention (11) of an electrocardiogram signal from each channel,
      detecting QRS complexes (140) in the delta-encoded ECG signals using linear predictors for decorrelating QRS complex and background component of the ECG signal,
      predictive encoding consisting of in-channel predictive encoding (12) using the provided in-channel predictor coefficients, selective for QRS complex and background component of the electrocardiogram signal and,

cross-channel predictive encoding (13) using cross-channel predictor coefficients and a suboptimal assignment employing assignment function for arranging correlated channels into a tree of dependencies,
entropy coding (14) of the cross-channel decorrelated ECG signals with the use of a variance of a prediction error,
multiplexing (15) multiple entropy encoded ECG signals from M channels, and outliers into one datastream,
wherein parameters of prediction and entropy coding are obtained during predictors training (2) for blocks with predefined length of ECG signal from at least one channel,
**characterized in that**
a determination of the suboptimal assignment is based on verifying the dependence between channels using the cross channel correlation, finding for each channel a channel with the highest correlation, and next determining a base channel which is the channel with the highest correlation of all these channels, wherein finding an assignment function in the suboptimal assignment comprises the following steps:

defining a set of connected channels comprising the base channel and a set of unconnected channels comprising all other channels,
moving from the set of unconnected channels to the set of connected channels the channels with the highest correlation with the base channel,
moving from the set of unconnected channels to the set of connected channels other channels with the highest correlation to the channels moved to the set of connected channels,
repeating this step until the set of unconnected channels is empty,
finishing the procedure if the set of unconnected channels is empty, or
if the set of unconnected channels is not empty and no channel with the highest correlation for these channels has been transferred from the set of unconnected channels to the set of connected channels, then finding among the channels in the set of unconnected channels the channel with the highest correlation to each other and moving this channel from the set of unconnected channels to the set of connected channels, and next moving from the set of unconnected channels to the set of connected channels all channels correlated with said channel.

2. The method according to claim 1, **characterized in that** predictors training (2) comprises the following steps:

delta coding (20) with overflow prevention (21),
detecting the QRS complexes,
estimation (24) of predictors coefficients for the in-channel predictive encoding,
in-channel predictive encoding (22),
estimation (26) of predictors coefficients for the cross-channel predictive encoding and estimation (25) of tree of dependencies,
cross-channel predictive encoding (23),
estimation (27) the variance of a prediction error.

3. The method according to claim 1 or 2, **characterized in that** predictors training (2) comprises of analyzing characteristics of the electrocardiogram signal with the use of a training sequence prediction preceding every block.

4. The method according to claim 1, **characterized in that** decoding (3) comprises following steps:

demultiplexing (30) the sequence of encoded symbols into multiple channels,
entropy decoding (31),
cross-channel predictive decoding (32) using the provided tree of dependencies and cross-channel predictor coefficients,
detecting the QRS complexes,
in-channel predictive decoding (33)separate for QRS complexes and background components of the electrocardiogram signal,
delta decoding (34) with reverse overflow protection.

5. The method according to claim 1, **characterized in that** the parameters of prediction and entropy decoding are provided along with the encoded data or obtained during predictors training, for blocks of electrocardiogram signal from at least one channel, where each block has predefined length.

6. The method according to claim 1, **characterized in that** the in-channel predictor coefficients and cross-channel predictor coefficients are calculated with the use of a least squares method.

7. The method according to claim 1, **characterized in that** the heartbeats and background components of the electrocardiogram signal are distinguished by comparing a local signal's magnitude to a magnitude of the most recent extremum in last samples, preceding the currently processed signal sample.

8. The method according to claim 1, **characterized in that** the predictors are linear.

9. A computer program comprising instructions which, when the program is executed by a computing device, causing the computing device to carry out the method according to any one of claims 1 to 8.

10. A computer system arranged to carry out the method according to any one of claims 1 to 8.

**Patentansprüche**

1. Verfahren zur verlustfreien Kompression eines Mehrkanal-Elektrokardiogrammsignals, das von einem Computersystem durchgeführt wird, umfassend: Kodierung (1), Prädiktoren-Training (2), Dekodierung (3), wobei die Kodierung (1) aus folgenden Schritten besteht:

Delta-Codierung (10), die an Input-EKG-Signalen durchgeführt wird, die von M-parallelen Kanälen gesammelt werden, Überlaufschutz (11) eines Elektrokardiogrammsignals von jedem Kanal, Erfassen von QRS-Komplexen (140) in den deltacodierten EKG-Signalen unter Verwendung von linearen Prädiktoren zum Dekorrelieren des QRS-Komplexes und der Hintergrundkomponente des EKG-Signals, prädiktive Codierung, die aus kanalinterner prädiktiver Codierung (12) unter Verwendung der bereitgestellten kanalinternen Prädiktorkoeffizienten besteht, die für den QRS-Komplex und die Hintergrundkomponente des Elektrokardiogrammsignals selektiv sind, und kanalübergreifende prädiktive Codierung (13) unter Verwendung von kanalübergreifenden Prädiktor-Koeffizienten und einer suboptimalen Zuweisung unter Verwendung einer Zuweisungsfunktion zum Anordnen korrelierter Kanäle in einem Abhängigkeitsbaum, Entropiekodierung (14) der kanalübergreifenden dekorrelierten EKG-Signale unter Verwendung einer Varianz eines Prädiktionsfehlers, Multiplexen (15) mehrerer entropiekodierter EKG-Signale von M-Kanälen und Ausreißern in einen Datenstrom, wobei Parameter der Prädiktion und der Entropiekodierung während des Prädiktoren-Trainings (2) für Blöcke mit vordefinierter Länge des EKG-Signals von mindestens einem Kanal erhalten werden, **dadurch gekennzeichnet, dass** eine Bestimmung der suboptimalen Zuweisung auf der Verifizierung der Abhängigkeit zwischen Kanälen unter Einsatz der Kreuzkanalkorrelation, dem Auffinden eines Kanals mit der höchsten Korrelation für jeden Kanal und der anschließenden Bestimmung eines Basiskanals basiert welcher der Kanal mit der höchsten Korrelation von all diesen Kanälen ist, wobei das Auffinden einer Zuweisungsfunktion in der suboptimalen Zuweisung die folgenden Schritte umfasst:

Definieren eines Sets von verbundenen Kanälen, der den Basiskanal umfasst, und eines Sets von unverbundenen Kanälen, der alle anderen Kanäle umfasst, Verschieben der Kanäle mit der höchsten Korrelation mit dem Basiskanal aus dem Set der unverbundenen Kanäle in dem Set der verbundenen Kanäle, Verschieben, von dem Set der unverbundenen Kanäle in das Set der verbundenen Kanäle, anderer Kanäle mit der höchsten Korrelation zu den in das Set der verbundenen Kanäle verschobenen Kanälen, Wiederholen dieses Schritts, bis das Set der unverbundenen Kanäle leer ist, Beenden des Verfahrens, wenn das Set der unverbundenen Kanäle leer ist, oder wenn das Set der unverbundenen Kanäle nicht leer ist und kein Kanal mit der höchsten Korrelation für diese Kanäle aus dem Set der unverbundenen Kanäle in das Set der verbundenen Kanäle übertragen wurde, dann wird unter den Kanälen in dem Set der unverbundenen Kanäle der Kanal mit der höchsten Korrelation zueinander gefunden und dieser Kanal aus dem Set der unverbundenen Kanäle in das Set der verbundenen Kanäle übertragen, und als nächstes werden alle mit diesem Kanal korrelierten Kanäle aus dem Set der unverbundenen Kanäle in das Set der verbundenen Kanäle übertragen.

2. Verfahren nach Anspruch 1, **dadurch gekennzeichnet, dass** das Training der Prädiktoren (2) aus folgenden Schritten besteht:

Delta-Codierung (20) mit Überlaufschutz (21), Detektion der QRS-Komplexe, Schätzung (24) der Prädiktor-Koeffizienten für die kanalinterne prädiktive Codierung, kanalinterne prädiktive Codierung (22), Schätzung (26) der Prädiktor-Koeffizienten für die kanalübergreifende prädiktive Kodierung und Schätzung (25) des Abhängigkeitsbaums, kanalübergreifende prädiktive Kodierung (23), Schätzung (27) der Varianz eines Vorhersagefehlers.

3. Verfahren nach Anspruch 1 oder 2, **dadurch gekennzeichnet, dass** das Training der Prädiktoren (2) die Analyse der Eigenschaften des Elektrokardiogrammsignals unter Nutzung einer Trainingssequenzvorhersage, die jedem Block vorausgeht.

4. Verfahren nach Anspruch 1, **dadurch gekennzeichnet, dass** die Dekodierung (3) aus den folgenden Schritten besteht: Demultiplexen (30) der Sequenz kodierter Symbole in mehrere Kanäle, Entropie-Dekodierung (31), kanalübergreifende prädiktive Dekodierung (32) unter Nutzung des bereitgestellten Abhängigkeitsbaums und der kanalübergreifenden Prädiktor-Koeffizienten, Detektion der QRS-Komplexe, kanalinterne prädiktive Dekodierung (33) getrennt für QRS -Komplexe und Hintergrundkomponenten des Elektrokardiogrammsignals, Delta-Decodierung (34) mit umgekehrtem Überlaufschutz.

5. Verfahren nach Anspruch 1, **dadurch gekennzeichnet, dass** die Parameter der Prädiktion und der Entropie-Dekodierung zusammen mit den kodierten Daten bereitgestellt oder während des Trainings der Prädiktoren für Blöcke des Elektrokardiogrammsignals von mindestens einem Kanal erhalten werden, wobei jeder Block eine vordefinierte Länge hat.

6. Verfahren nach Anspruch 1, **dadurch gekennzeichnet, dass** die kanalinternen Prädiktor-Koeffizienten und die kanalübergreifenden Prädiktor-Koeffizienten unter Nutzung einer Methode der kleinsten Quadrate kalkuliert werden.

7. Verfahren nach Anspruch 1, **dadurch gekennzeichnet, dass** die Herzschläge und Hintergrundkomponenten des Elektrokardiogrammsignals unterschieden werden, indem die Größe eines lokalen Signals mit der Größe des letzten Extremwerts in den letzten Proben (Samples) verglichen wird, die der aktuell verarbeiteten Signalprobe vorausgehen.

8. Verfahren nach Anspruch 1, **dadurch gekennzeichnet, dass** die Prädiktoren linear sind.

9. Ein Computerprogramm, das Befehle enthält, die, wenn das Programm von einem Computergerät ausgeführt wird, die das Computergerät dazu veranlassen, das Verfahren nach einem der Ansprüche 1 bis 8 auszuführen.

10. Ein Computersystem, das zur Durchführung des Verfahrens nach einem der Ansprüche 1 bis 8 eingerichtet ist.

**Revendications**

1. Méthode de compression sans perte d'un signal d'électrocardiogramme multicanal exécutée par un système informatique comprenant : le codage (1), l'apprentissage des prédicteurs (2), le décodage (3), dans laquelle le codage (1) comprend les étapes suivantes:

codage delta (10) des signaux ECG d'entrée collectés à partir de M canaux parallèles, empêchant le débordement (11) du signal d'électrocardiogramme de chaque canal, détectant les complexes QRS (140) dans les signaux ECG codés delta à l'aide de prédicteurs linéaires pour décorréler le complexe QRS et la composante de fond du signal ECG, codage prédictif consistant en un codage prédictif intra-canal (12) utilisant des coefficients prédicteurs intra-canal fournis, sélectifs pour le complexe QRS et la composante de fond du signal ECG, et codage prédictif inter-canal (13) en utilisant des coefficients de prédicteur inter-canal et une affectation sous-optimale utilisant une fonction d'affectation pour organiser des canaux corrélés dans un arbre de dépendance, le codage entropique (14) des signaux ECG corrélés entre canaux utilisant la variance d'erreur de prédiction, multiplexage (15) de plusieurs signaux ECG codés entropiques, provenant de M canaux, et de valeurs aberrantes en un flux de données,
dans lequel les paramètres de prédiction et de codage entropique sont obtenus en apprenant les prédicteurs (2) pour des blocs d'une certaine longueur du signal ECG provenant d'au moins un canal, **caractérisés en ce que** la détermination de l'affectation sous-optimale est basée sur la vérification de la relation entre les canaux au moyen d'une corrélation inter-canaux, pour chaque canal, en trouvant pour chaque canal le canal ayant la corrélation la plus élevée et en déterminant ensuite le canal de base, qui est le canal avec la corrélation la plus élevée parmi tous ces canaux,

et la recherche de la fonction d'affectation dans l'affectation sous-optimale comprend les étapes suivantes:

> définir un ensemble de canaux connectés comprenant le canal de base et un ensemble de canaux non connectés comprenant tous les autres canaux,
> transférer de l'ensemble de canaux non connectés à l'ensemble de canaux connectés les canaux présentant la corrélation la plus élevée avec le canal de base,
> transférer de l'ensemble de canaux non connectés à l'ensemble de canaux connectés d'autres canaux avec la corrélation la plus élevée avec les canaux déplacés vers l'ensemble de canaux connectés, en répétant cette étape jusqu'à ce que l'ensemble de canaux non connectés soit vide, en terminant la procédure lorsque l'ensemble de canaux non connectés soit vide ou
> si l'ensemble des canaux non connectés n'est pas vide et qu'aucun canal avec la corrélation la plus élevée pour ces canaux n'a été déplacé de l'ensemble des canaux non connectés vers l'ensemble des canaux connectés, trouver parmi les canaux de l'ensemble des canaux non connectés celui qui a la plus haute corrélation avec soi et déplacer ce canal d'un ensemble de canaux non connectés vers l'ensemble de canaux connectés, puis transférer de l'ensemble de canaux non connectés vers l'ensemble de canaux connectés tous les canaux corrélés avec ce canal.

**2.** Méthode selon l'affirmation 1, **caractérisée en ce que** l'apprentissage des prédicteurs (2) comprend les étapes suivantes : codage delta (20) avec prévention de débordement (21), détection de complexes QRS, estimation (24) de coefficients des prédicteurs pour le codage prédictif intra-canal, codage prédictif intra-canal (22), estimation (26) des coefficients des prédicteurs pour le codage prédictif inter-canal et estimation (25) de l'arbre de dépendance du codage prédictif inter-canal (23), estimation (27) de la variance de l'erreur de prédiction.

**3.** Méthode selon l'affirmation 1 ou 2, **caractérisé en ce que** l'apprentissage des prédicteurs (2) comprend une analyse des caractéristiques du signal d'électrocardiogramme à l'aide de la prédiction de la séquence d'apprentissage précédant chaque bloc.

**4.** Méthode selon l'affirmation 1, **caractérisée en ce que** le décodage (3) comprend les étapes suivantes : démultiplexage (30) de la séquence de symboles codés en plusieurs canaux, décodage entropique (31), décodage prédictif inter-canaux (32) à l'aide d'un arbre de dépendance fourni et des coefficients de prédiction inter-canal, détection des complexes QRS, décodage prédictif intra-canal (33) séparé pour les complexes QRS et les composantes de fond du signal ECG, décodage delta (34) avec protection contre le débordement inversé.

**5.** Méthode selon l'affirmation 1, **caractérisée en ce que** les paramètres de prédiction et de décodage entropique sont fournis avec les données codées, ou obtenus pendant l'apprentissage des prédicteurs, pour des blocs d'un signal d'électrocardiogramme provenant d'au moins un canal, chaque bloc ayant une longueur prédéfinie.

**6.** Méthode selon l'affirmation 1, **caractérisée en ce que** les coefficients du prédicteur intracanal et les coefficients du prédicteur intercanal sont calculés par les moindres carrés.

**7.** Méthode selon l'affirmation 1, **caractérisée en ce que** le rythme cardiaque et les composantes de fond du signal d'électrocardiogramme sont distingués en comparant la taille du signal local avec la taille du dernier extrême dans les derniers échantillons précédant l'échantillon de signal actuellement traité

**8.** Méthode selon l'affirmation 1, **caractérisée en ce que** les prédicteurs sont linéaires.

**9.** Programme informatique contenant des instructions qui, lorsqu'elles sont exécutées par un dispositif informatique, amènent le dispositif informatique à exécuter la méthode selon l'une des affirmations 1 à 8.

**10.** Système informatique adapté pour mettre en œuvre la méthode selon l'une des affirmations 1 à 8.

EP 3 764 548 B1

1

Input signal

$x_1(k)$

$x_2(k)$

$\vdots$

$x_M(k)$

10 11

Delta encoding & overflow prevention

$y_1(k)$

$y_2(k)$

$\vdots$

$y_M(k)$

12

$\mathbf{A}_i^{qrs}, \mathbf{A}_i^{bg}$

In-channel predictive encoding

$z_1(k)$

$z_2(k)$

$\vdots$

$z_M(k)$

13

$\mathbf{B}_i, N_i(m)$

Cross-channel predictive encoding

$v_1(k)$

$v_2(k)$

$\vdots$

$v_M(k)$

14

$\sigma_i^2$

Entropy encoding

$c_{1,i}$

$c_{2,i}$

$\vdots$

$c_{M,i}$

For $i = 1$ parameters of 1st block:

$\mathbf{A}_1^{qrs}, \mathbf{A}_1^{bg}, \mathbf{B}_1, N_1(m), \sigma_1^2$

15

Multiplexing

Encoded data

Bitstream

$\mathbf{Y}_i^*, \mathbf{K}_i$

Fig. 1

Fig. 2

Fig. 3

120

$y_m(k)$ $\qquad$ $z_m(k)$

$A_m(z)$ $\quad$ $\lceil \cdot \rfloor$

121 $\qquad$ 122

Fig. 4a

320

$y_m(k)$ $\qquad$ $z_m(k)$

$\lceil \cdot \rfloor$ $\leftarrow$ $A_m(z)$

Fig. 4b

$y_m(k)$ $\qquad$ $z_m(k)$

$A_{m,i}^{\mathrm{bg}}(z)$

$A_{m,i}^{\mathrm{qrs}}(z)$

$| \cdot |$ $\quad$ $H_{\mathrm{avg}}(z)$ $\qquad$ $\lceil \cdot \rfloor$

140

Local max $\quad$ $\div$ $\quad$ $\theta \lessgtr$

Fig. 5a

$z_m(k)$ $y_m(k)$

$A^{bg}_{m,i}(z)$ $A^{qrs}_{m,i}(z)$ $\lceil \cdot \rceil$ $|\cdot|$ $H_{avg}(z)$ $y^{avg}_m(k)$ Local max $\div$ $\overline{y^{avg}_m}(k)$ $\theta \lessgtr$

340

Fig. 5b

13

130

Cross-channel predictors' coefficients

$\mathbf{b}_{1,i}$ $\mathbf{b}_{2,i}$ $\cdots$ $\mathbf{b}_{M,i}$

$z_1(k)$ Cross-channel predictive encoder $v_1(k)$

$z_2(k)$ Cross-channel predictive encoder $v_2(k)$

$z_M(k)$ Cross-channel predictive encoder $v_M(k)$

$\cdots$

$z_{N_i(1)}(k)$ $z_{N_i(2)}(k)$ $\cdots$ $z_{N_i(M)}(k)$

Dependency tree $N_i(m)$ Multiplexing

Fig. 6a

22

33

Cross-channel predictors' coefficients

$\mathbf{b}_{1,i}$      $\mathbf{b}_{2,i}$     ...     $\mathbf{b}_{M,i}$

$v_1(k)$ → Cross-channel predictive decoder → $z_1(k)$

$v_2(k)$ → Cross-channel predictive decoder → $z_2(k)$

$v_M(k)$ → Cross-channel predictive decoder → $z_M(k)$

$z_{N_i(1)}(k)$    $z_{N_i(2)}(k)$    ...    $z_{N_i(M)}(k)$

Multiplexing

Dependency tree

$\overline{N_i(m)}$

Fig. 6b

130

$z_m(k)$ → (+) → $v_m(k)$

$z_n(k)$ → $B_{m,i}(z)$ → $\lceil \cdot \rceil$ → −

132

131

Fig. 7a

330

$v_m(k)$ → (+) → $z_m(k)$

$z_n(k)$ → $B_{m,i}(z)$ → $\lceil \cdot \rceil$

Fig. 7b

Fig. 8

Fig. 9a

Fig. 9b

Fig. 10

$K_{train}$

$K_{train}$

**Training**

Train to obtain
$\mathbf{A}_{i+1}^{qrs}$ , $\mathbf{A}_{i+1}^{bg}$, $\mathbf{B}_{i+1}$, $N_{i+1}(m)$, $\sigma_{i+1}^2$

Train to obtain
$\mathbf{A}_{i+2}^{qrs}$ , $\mathbf{A}_{i+2}^{bg}$, $\mathbf{B}_{i+2}$, $N_{i+2}(m)$, $\sigma_{i+2}^2$

**Encoding**

Encode $i$-th block using
$\mathbf{A}_i^{qrs}$ , $\mathbf{A}_i^{bg}$, $\mathbf{B}_i$, $N_i(m)$, $\sigma_i^2$

Encode $(i+1)$-th block using
$\mathbf{A}_{i+1}^{qrs}$ , $\mathbf{A}_{i+1}^{bg}$, $\mathbf{B}_{i+1}$, $N_{i+1}(m)$, $\sigma_{i+1}^2$

$k$

$K_{block}$

$K_{block}$

Fig. 11

## REFERENCES CITED IN THE DESCRIPTION

**Patent documents cited in the description**

- US 8917779 B2

- EP 1574067 B1

**Non-patent literature cited in the description**

- **C. J. DEEPU ; Y. LIAN.** A Joint QRS Detection and Data Compression Scheme for Wearable Sensors. *IEEE Trans. Biomed. Engineering*
- **D.-S. KIM ; J.-S. KWON.** A lossless multichannel bio-signal compression based on low-complexity joint coding scheme for portable medical devices. *Sensors,* September 2014

- **IGNACIO CAPURRO et al.** *Efficient sequential compression of multi-channel biomedical signals,* 14 May 2016